Europäisches Patentamt

European Patent Office

Office européen des brevets

(19)

(11) Numéro de publication: **0 197 991**
**B1**

## (12) FASCICULE DE BREVET EUROPEEN

(45) Date de publication du fascicule du brevet:
18.01.89

(21) Numéro de dépôt: **85904985.0**

(22) Date de dépôt: **11.10.85**

(86) Numéro de dépôt international:
**PCT/FR 85/00288**

(87) Numéro de publication internationale:
**WO 86/02489 (24.04.86 Gazette 86/9)**

(51) Int. Cl.⁴: **H 01 L 21/84, H 01 L 27/13**

(54) **PROCEDE DE FABRICATION DE CIRCUITS ELECTRONIQUES A BASE DE TRANSISTORS EN COUCHES MINCES ET DE CONDENSATEURS.**

(30) Priorité: **17.10.84 FR 8415898**

(43) Date de publication de la demande:
**22.10.86 Bulletin 86/43**

(45) Mention de la délivrance du brevet:
**18.01.89 Bulletin 89/3**

(84) Etats contractants désignés:
**BE DE GB IT NL SE**

(56) Documents cités:
**EP-A- 0 082 783**
**US-A- 4 332 075**

**Electronics International, vol. 55, no. 10, 19 May 1982, New York, US R.T. GALLAGHER:" Amorphous silicon enlarges LCD's", pages 94-96**

(73) Titulaire: **ETAT FRANCAIS représenté par le Ministre des PTT (Centre National d'Etudes des Télécommunications), 38-40 rue du Général Leclerc, F-92131 Issy-les-Moulineaux (FR)**

(72) Inventeur: **COISSARD, Pierre, 6, Résidence Argensol, F-84100 Orange (FR)**
Inventeur: **RICHARD, Joseph, 33, Lotissement Keranroux-Ploubezre, F-22300 Lannion (FR)**
Inventeur: **MORIN, François, Le Carpont Laumerin, F-22300 Lannion (FR)**

(74) Mandataire: **Mongrédien, André et al, c/o BREVATOME 25, rue de Ponthieu, F-75008 Paris (FR)**

## Description

Dans le document FR-A-2 533 072, il est décrit un procédé de fabrication d'un écran d'affichage à matrice active dans lequel on réalise une paroi inférieure portant des armatures de condensateurs et des transistors à couches minces et une paroi supérieure revêtue d'une contre-électrode formant seconde armature des condensateurs. Le procédé faisant l'objet de ce document est caractérisé en ce que, pour réaliser la paroi inférieure, on procède aux opérations suivantes:

— dépôt sur un substrat isolant d'une couche d'un premier matériau conducteur transparent,

— première photogravure appliquée à cette première couche pour constituer des lignes et des colonnes de pavés formant une des armatures des futurs condensateurs, chaque pavé étant relié à une appendice, cette première photogravure laissant subsister en outre des colonnes dudit premier matériau conducteur, ces colonnes étant disposées entre les colonnes de pavés,

— dépôt d'une couche de silicium amorphe hydrogéné sur l'ensemble,

— dépôt d'une couche isolante,

— dépôt d'une couche d'un second matériau conducteur,

— seconde photogravure appliquée à l'ensemble couche de silicium - couche isolante - couche conductrice, cette seconde photogravure laissant subsister des lignes du second matériau conducteur, ces lignes passant au-dessus des appendices, les zones de recouvrement d'une ligne avec une colonne et un appendice définissant la source et le drain d'un transistor, la grille de ce transistor étant constituée par la partie de la ligne qui est située entre l'appendice et la colonne.

Dans une variante de ce procédé, et afin d'améliorer le contact entre l'oxyde et la couche de aSiH, il est prévu qu'on dépose, après l'oxyde, une couche de silicium amorphe fortement dopé n. La première gravure est toujours réalisée à l'aide du même masque, mais cette gravure affecte alors à la fois la couche de silicium dopé et celle d'oxyde. Quant à la seconde photogravure elle n'est pas modifiée.

La présente invention a pour objet une variante de ce procédé dans laquelle on fait encore usage de cette couche supplémentaire de silicium amorphe dopé, mais dans laquelle on modifie légèrement la seconde gravure.

Dans le document antérieur, au cours de la seconde gravure, le silicium dopé est attaqué à la suite du silicium semiconducteur. Le silicium dopé ne subsiste donc que sous la grille, au-dessus de l'oxyde (voir figure 7b du brevet principal).

Bien que les résultats obtenus avec la variante décrite dans le document antérieur aient démontré la validité du procédé et l'intérêt de sa simplicité, les écrans obtenus peuvent, dans certains cas, présenter quelques défauts qui proviennent de coupures de colonnes. Ces coupures se manifestent lorsqu'on utilise, comme substrat de départ, un verre type «Balzers» recouvert d'une très fine couche d'oxyde d'indium-étain. Les fines rayures «naturelles» de ces substrats standards (qui sont peu chers, car utilisés déjà dans les afficheurs à cristaux liquides) ne permettent pas de réaliser des bandes très fines (d'environ 20 µm) avec un rendement de 100%. Il faut donc, soit réaliser les couches transparentes et conductrices sur des substrats de meilleure qualité, soit introduire une redondance pour guérir les colonnes coupées.

C'est cette deuxième solution qui fait l'objet de la présente invention.

Cette redondance est obtenue en modifiant légèrement le second niveau de masquage de telle sorte qu'après gravure il subsiste, sur une partie des colonnes, l'empilement formé par la couche de silicium dopé n et les couches suivantes. Cet empilement joue alors, en cas de coupure de la colonne, le rôle de pont conducteur entre les deux parties de celle-ci. On obtient ainsi une redondance électrique dans la conception des colonnes d'adressage puisque deux conducteurs sont prévus en parallèle, le deuxième venant pallier les défauts éventuels du premier.

Cet artifice présente un autre avantage: l'empilement préservé produit un masquage optique de la colonne transparente. Si la colonne n'est pas masquée, elle est visible au même titre qu'un point d'affichage. Son aspect dépend de la valeur moyenne de la tension vidéo pendant une image. Cet effet est très gênant dans le mode d'affichage blanc sur fond noir, car l'oeil est très sensible aux lignes blanches même très fines. Dans l'autre mode, noir sur fond blanc, l'effet est beaucoup moins visible, une ligne noire de 20 µm de large sur fond blanc étant invisible à l'oeil. Le masquage optique des colonnes transparentes est donc nécessaire surtout dans le premier mode et il est parfaitement réalisé par la présente invention.

On notera que le perfectionnement préconisé par l'invention n'introduit aucune opération supplémentaire, puisque c'est simplement le dessin du second niveau de masquage qui est légèrement modifié.

Il est à noter également que, dans le cas de coupures très larges, la résistance du pont de silicium dopé peut devenir importante. Mais les deux parties de la colonne se trouvent quand même reliées électriquement et cela par couplage capacitif.

De toute façon, les caractéristiques de l'invention apparaîtront mieux après la description qui suit, d'un exemple de réalisation donné à titre explicatif et nullement limitatif. Cette description se réfère à des dessins annexés sur lesquels:

la figure 1 montre les étapes essentielles du procédé de l'invention,

la figure 2 montre un détail de l'écran obtenu,

la figure 3 montre, en coupe, le segment qui subsiste sur les colonnes après seconde gravure,

la figure 4 est un schéma électrique équivalent qui illustre le principe de la redondance électrique introduite par l'invention.

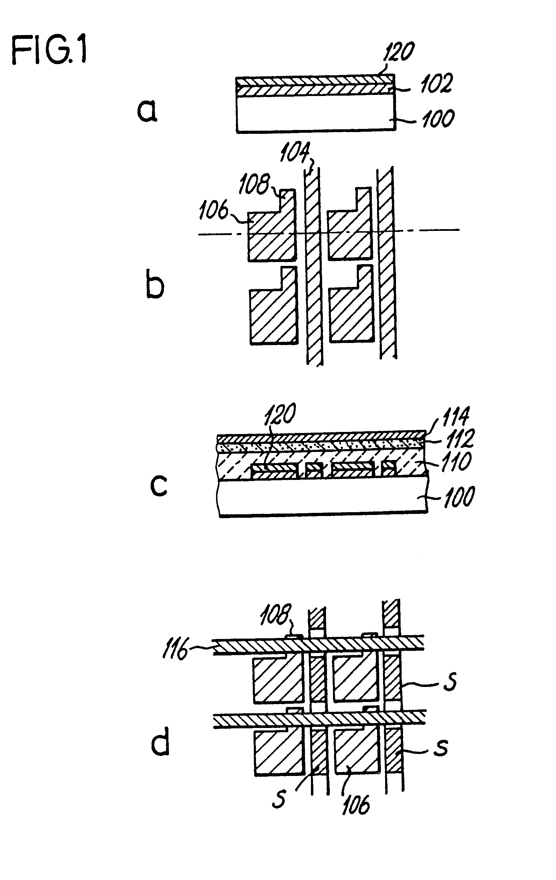

Les différentes opérations que comprend le procédé de l'invention sont illustrées sur la figure 1 qui montre différents états intermédiaires de l'écran obtenu. Ces opérations sont les suivantes:

— dépôt d'une couche 120 de silicium amorphe fortement dopé n, sur un substrat de verre 100, par exemple de la marque Balzers, revêtu préalablement d'une couche 102 de matériau conducteur transparent, par exemple en oxyde d'étain et d'indium,

— première photogravure appliquée à ces deux couches pour constituer une mosaïque de pavés 106 rangés en lignes et colonnes, ces pavés formant une des armatures des futurs condensateurs; chaque pavé est relié à un appendice 108; cette première photogravure laisse subsister en outre des colonnes 104 du premier matériau conducteur 102 surmonté de la couche 120 de silicium amorphe fortement dopé n, ces colonnes s'insérant entre les colonnes de pavés (figure 1b),

— dépôt d'une couche 110 de silicium amorphe hydrogéné sur l'ensemble,

— dépôt d'une couche isolante 112, en silice par exemple,

— dépôt d'une couche 114 d'un second matériau conducteur, par exemple en aluminium (figure 1c),

— seconde photogravure appliquée à l'ensemble des couches 120, 110, 112, 114 pour dégager chaque pavé et laisser subsister des lignes 116 du second matériau conducteur 114; des segments S de l'empilement subsistent sur les colonnes, sur une partie de l'intervalle séparant deux lignes consécutives; cette seconde photogravure ne dégage le matériau conducteur transparent 102 des colonnes qu'à chaque extrémité de ces intervalles (figure 1d),

— dépôt d'une couche de $SiO_2$ destinée à passiver l'ensemble.

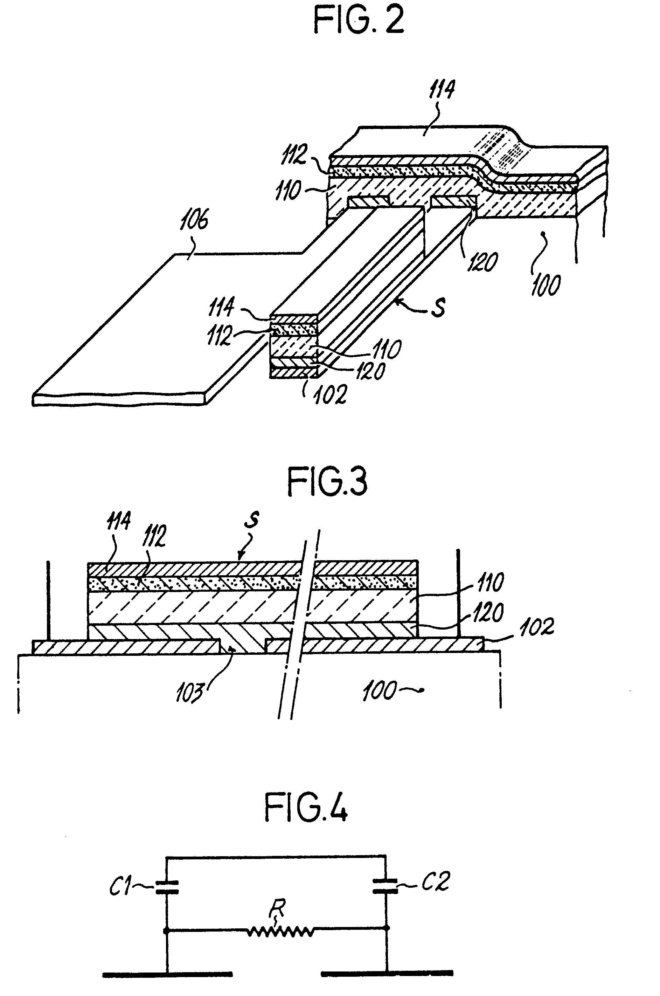

La position et la structure des segments S maintenus sur les colonnes après la seconde photogravure apparaissent mieux sur les figures 2 et 3.

Le rôle de ce segment est explicité sur les figures 3 et 4. Sur la figure 3, on voit le cas d'une colonne 102 présentant une coupure 103. Le pont conducteur réalisé par le segment S et notamment par la couche 120 en silicium amorphe fortement dopé rétablit la continuité électrique. Si la coupure 103 est très large, la continuité électrique est quand même assurée (malgré la résistance R non négligeable présentée par le segment de silicium portant la coupure) par les deux capacités $C_1$ et $C_2$ formées par les deux parties de la couche 102 et la couche conductrice 114. Le schéma électrique équivalent est représenté sur la figure 4.

**Revendication**

Procédé de fabrication d'un écran d'affichage à matrice active dans lequel on réalise une paroi inférieure portant des armatures de condensateurs et des transistors à couches minces et une paroi supérieure revêtue d'une contre-électrode formant seconde armature des condensateurs, dans lequel, pour réaliser la paroi inférieure, on procède aux opérations suivantes:

— sur un substrat isolant (100) recouvert d'une couche (102) d'un premier matériau conducteur transparent, dépôt d'une couche (120) de silicium amorphe fortement dopé n,

— première photogravure appliquée à ces deux couches pour constituer une mosaïque de pavés (106) rangés en lignes et colonnes, ces pavés (106) formant une des armatures des futurs condensateurs, chaque pavé étant relié à un appendice (108), cette première photogravure laissant subsister en outre des colonnes (104) dudit premier matériau conducteur surmonté de la couche (120) de silicium amorphe fortement dopé n, ces colonnes s'insérant entre les colonnes de pavés,

— dépôt d'une couche (110) de silicium amorphe hydrogéné sur l'ensemble,

— dépôt d'une couche isolante (112),

— dépôt d'une couche (114) d'un second matériau conducteur,

— seconde photogravure appliquée à l'empilement de couches (120, 110, 112, 114) pour dégager chaque pavé, mais laisser subsister des lignes (116) du second matériau conducteur (114), cette seconde photogravure laissant subsister en outre des segments (S) de cet empilement sur les colonnes, sur une partie des intervalles séparant deux lignes consécutives, cette seconde photogravure ne dégageant le matériau conducteur transparent (102) des colonnes qu'à chaque extrémité de ces intervalles.

**Patentanspruch**

Verfahren zur Herstellung eines aktiven Matrixanzeigefeldes, bei dem man eine untere Wand, die Kondensatorplatten und Dünnschichttransistoren trägt, und eine obere Wand ausbildet, die von einer Gegenelektrode bedeckt ist, die die zweite Platte der Kondensatoren bildet, wobei man zur Herstellung der unteren Wand die folgenden Schritte ausführt:

— auf einem Isoliersubstrat (100), das von einer ersten transparenten Leitermaterialschicht (102) bedeckt ist, wird eine Schicht (120) aus stark n-dotiertem amorphem Silicium aufgebracht,

— die genannten zwei Schichten werden einer ersten Fotoätzung unterzogen, um ein Mosaik aus Blöcken (106) auszubilden, die in Zeilen und Spalten angeordnet sind, wobei diese Blöcke (106) eine der Platten der zukünftigen Kondensatoren bilden, jeder Block mit einem Fortsatz (108) verbunden ist, diese erste Fotoätzung darüber hinaus Spalten (104) der genannten ersten Leitermaterialschicht weiterbestehen lässt, die über der Schicht (120) aus stark n-dotiertem amorphem Silicium liegt und diese Spalten sich zwischen die Spalten der Blöcke einfügen,

— auf der Anordnung wird eine Schicht (110) aus hydriertem amorphem Silicium aufgebracht,

— es wird eine Isolierschicht (112) aufgebracht,

— es wird eine Schicht (114) aus einem zweiten Leitermaterial aufgebracht,

— die übereinanderliegenden Schichten (120, 110, 112, 114) werden einer zweiten Fotoätzung unterworfen, um jeden Block freizulegen, jedoch die Leitungen (116) des zweiten Leitermaterials (114) zurückzulassen, wobei diese zweite Fotoätzung darüber hinaus Segmente (S) des Fichtenstapels über den Spalten über einem Teil der Zwischenräume zurücklässt, die zwei aufeinanderfolgende Leitungen trennt, wobei diese zweite Fotoätzung das transparente Leitermaterial (102) der Spalten nur an jedem Ende dieser Zwischenräume freilegt.

**Claim**

Process for fabricating an active matrix display screen in which there is produced a lower wall carrying capacitor plates and thin-film transistors and an upper wall coated with a counter-electrode forming second capacitor plates, characterized in that, to produce the lower wall, the following operations are carried out:

— a layer (120) of highly n-doped amorphous silicon is deposited on an insulative substrate (100) covered with a layer (102) of a first transparent conductive material,

— these two layers are photoetched to constitute a mosaic of pads (106) arranged in lines and colums, these pads (106) forming one of the plates of the eventual capacitors, each pad being joined to an appendix (108), this first photoetching also leaving columns (104) of said first conductive material overlaid by the layer (120) of higly n-doped amorphous silicon, these columns being situated between the columns of pads,

— depositing a layer (110) of hydrogenated amorphous silicon over everything,

— depositing an insulative layer (112),

— depositing a layer (114) of a second conductive material,

— photoetching the stack of layers (120, 110, 112, 114) to expose each pad but so as to leave lines (116) of the second conductive material (114), this second photoetching also leaving segments (S) of this stack over the columns over a part of the gaps between two consecutive lines, this second photoetching exposing the transparent conductive material (102) of the columns only at each end of these gaps.

# FIG.1

EP 0 197 991 B1

# FIG. 2

# FIG.3

# FIG.4

7